# FASCICULE DE BREVET EUROPEEN

(11) **EP 1 297 576 B1**
(45) Date de publication et mention de la délivrance du brevet: **04.05.2011**
(21) Numéro de dépôt: 01949551.4
(22) Date de dépôt: 29.06.2001
(51) Int. Cl.: H01L 31/0232

(54) **DISPOSITIF OPTOELECTRONIQUE A FILTRAGE DE LONGUEUR D'ONDE INTEGRE**
INTEGRIERTE OPTOELEKTRONISCHE VORRICHTUNG ZUM FILTERN VON WELLELÄNGEN
OPTOELECTRONIC DEVICE WITH INTEGRATED WAVELENGTH FILTERING

(30) Priorité: 29.06.2000 FR 0008434
(43) Date de publication de la demande: 02.04.2003
(73) Titulaire: CENTRE NATIONAL DE LA RECHERCHE SCIENTIFIQUE (CNRS), 75016 Paris (FR); ECOLE CENTRALE DE LYON, 69131 Ecully Cédex (FR)
(72) Inventeur: VIKTOROVITCH, Pierre, F-69160 Tassin (FR); GARRIGUES, Michel, F-69890 La Tour de Salvagny (FR); LECLERCQ, Jean-Louis, F-69480 Morance (FR)
(74) Mandataire: Ramey, Daniel
(86) Numéro de dépôt international: PCT/FR2001/002046
(87) Numéro de publication internationale: WO 2002/001604

(56) Documents cités:
- WO-A-99/05723
- US-A- 5 286 976
- US-A- 5 315 128
- DEHE A ET AL: "III-V compound semiconductor micromachined actuators for long resonator tunable Fabry-Perot detectors" SENSORS AND ACTUATORS A, ELSEVIER SEQUOIA S.A., LAUSANNE, CH, vol. 68, no. 1-3, 15 juin 1998 (1998-06-15), pages 365-371, XP004139861 ISSN: 0924-4247
- J.PFEIFFER ET AL.: "Tunable wavelength-selective WDM photodetector based on MOEMS" ANNUAL REPORT TECHNICAL UNIVERSITY DARMSTAD, 1999, pages 94-98, XP002195782
- BONDAVALLI P ET AL: "Optical and mechanical design of an InP based tunable detector for gas sensing applications" MINIATURIZED SYSTEMS WITH MICRO-OPTICS AND MEMS, SANTA CLARA, CA, USA, 20-22 SEPT. 1999, vol. 3878, pages 174-184, XP002195783 Proceedings of the SPIE - The International Society for Optical Engineering, 1999, SPIE-Int. Soc. Opt. Eng, USA ISSN: 0277-786X
- DALEIDEN J ET AL: "Tunable InP/air gap Fabry Perot filter for wavelength division multiplex fiber optical transmission" CONFERENCE PROCEEDINGS. ELEVENTH INTERNATIONAL CONFERENCE ON INDIUM PHOSPHIDE AND RELATED MATERIALS (IPRM'99) (CAT. NO.99CH36362), CONFERENCE PROCEEDINGS. ELEVENTH INTERNATIONAL CONFERENCE ON INDIUM PHOSPHIDE AND RELATED MATERIALS (IPRM'99), DAVOS, S, pages 285-287, XP002195784 1999, Piscataway, NJ, USA, IEEE, USA ISBN: 0-7803-5562-8
- LECIERCQ J -L ET AL: "InP-based MOEMS and related topics" 10TH MICROMECHANICS EUROPE WORKSHOP (MME'99), GIF SUR YVETTE, FRANCE, 27-28 SEPT. 1999, vol. 10, no. 2, pages 287-292, XP008002312 Journal of Micromechanics and Microengineering, June 2000, IOP Publishing, UK ISSN: 0960-1317

## Description

L'invention concerne les dispositifs optoélectroniques qui combinent une fonction de conversion (en réception ou en émission) à une fonction de filtrage en longueur d'onde des ondes lumineuses reçues ou émises.

On entend par « conversion » une transformation de type photoélectrique, à l'émission ou à la réception, mais également une transformation de type géométrique qui modifie par diffraction certaines caractéristiques d'une onde lumineuse en vue d'assurer son contrôle spatial.

Des dispositifs de ce type sont couramment utilisés pour la photodétection sélective en longueur d'onde, notamment. Ils consistent généralement en des moyens de filtrage, tels qu'une cavité optique résonnante de type Fabry-Pérot, associés à des moyens de réception, tels qu'un photodétecteur. Le document WO 99/05723 décrit un bolomètre comprenant un photodétecteur infrarouge placé entre la lumière incidente et une cavité formée d'une couche supérieure d'absorption et d'une couche inférieure réfléchissant des infrarouges et transmettant les radiations visibles.

Dans un premier mode de réalisation connu d'un dispositif de photodétection sélective, les moyens de filtrage reçoivent l'onde lumineuse incidente, transmettent aux moyens de réception la partie de l'onde lumineuse qui présente une longueur d'onde centrée sur une valeur choisie et rejettent la partie complémentaire de l'onde incidente. En d'autres termes, le filtre optique se trouve placé entre la source de lumière et les moyens de conversion (par exemple le détecteur).

Le même principe connu s'applique pour réaliser des sources émettant un spectre de longueurs d'onde contrôlé. Dans une telle source, les moyens de filtrage reçoivent l'onde lumineuse émise par un émetteur photoélectrique (par exemple une diode électroluminescente), transmettent une longueur d'onde centrée sur une valeur choisie et rejettent la partie complémentaire. Le filtre est donc placé sur le trajet situé entre les moyens d'émission de lumière et le système qui utilise l'onde lumineuse filtrée.

Dans ce mode de réalisation de dispositif optoélectronique, il est extrêmement difficile, voire impossible, de mettre en oeuvre une technologie dite « monolithique » reposant sur des procédés de fabrication pouvant être conduits successivement et indépendamment. Une technologie « hybride » s'impose donc pratiquement pour le report du filtre sur le dispositif de conversion (photodétecteur ou émetteur électroluminescent, par exemple), ce qui induit des difficultés importantes, lesquelles sont encore accrues lorsque le filtre est du type « Micro-Opto-Electro-Mécanique » (plus connu sous l'acronyme MOEM).

Dans un second mode de réalisation connu, adapté à la détection et à l'émission, le photodétecteur ou l'émetteur électroluminescent est inséré à l'intérieur d'une cavité que comprennent les moyens de filtrage. On parle alors de photodétecteur résonnant (en anglais « Resonant Cavity Enhanced Photodetector ») ou de diode électroluminescente résonnante (en anglais « Resonant Cavity Light Emitting Diode») comme décrit par Leclerq et al dans l'article "InP- based MOEMS and related topics", J. Micro eng. Micro eng. 10 (2000) 287-292, UK.

Dans ce mode de réalisation, on rencontre des difficultés similaires à celles décrites précédemment, en raison du report d'un miroir de Bragg « supérieur » au-dessus du photodétecteur ou de l'émetteur.

De plus, quel que soit le mode de réalisation, les limitations technologiques sont d'autant plus pénalisantes que les performances requises pour le dispositif sont contraignantes. Il est donc quasiment exclu d'utiliser ces dispositifs dans certains domaines, tels que le multiplexage en longueur d'onde dans les télécommunications optiques.

L'invention a pour but de remédier à tout ou partie des inconvénients précités.

Elle propose à cet effet un dispositif optoélectronique comprenant des moyens de conversion photoélectrique ou par diffraction des ondes lumineuses, des moyens de filtrage et des moyens de réflexion des ondes lumineuses, caractérisé en ce que les moyens de filtrage sont placés entre les moyens de conversion et les moyens de réflexion, à une distance d1 des moyens de conversion pour transmettre une partie spectrale choisie des ondes lumineuses provenant des moyens de conversion et à réfléchir vers lesdits moyens de conversion une partie spectrale complémentaire de ces ondes, les moyens de réflexion étant placés à une distance d2 des moyens de conversion pour renvoyer la partie spectrale choisie transmise par les moyens de filtrage vers lesdits moyens de filtrage, la distance d1 étant choisie de sorte que les ondes transmises par les moyens de conversion et la partie spectrale complémentaire réfléchie par les moyens de filtrage créent une première onde stationnaire avec un noeud de champ électrique dans lesdits moyens de conversion, et la distance d2 étant choisie de sorte que la partie spectrale choisie transmise par les moyens de filtrage et la partie spectrale choisie et réfléchie par les moyens de réflexion créent une seconde onde stationnaire avec un ventre de champ électrique dans lesdits moyens de conversion. Ainsi, dans le dispositif selon l'invention, les moyens de filtrage sont situés, en quelque sorte, « en dehors » du trajet habituel que suivent les ondes lumineuses reçues ou émises par les moyens de conversion pour rejoindre le dispositif devant les utiliser une fois filtrées (photodétecteur ou autre). En d'autres termes, les moyens de filtrage ne se trouvent plus situés entre la source d'ondes lumineuses à filtrer et le dispositif utilisant les ondes filtrées.

Lorsque le champ électrique associé à une onde stationnaire présente un noeud dans les moyens de conversion, l'interaction de l'onde stationnaire avec les moyens de conversion est nulle ou quasi nulle. En revanche, lorsque le champ électrique associé à une onde stationnaire présente un ventre dans les moyens de conversion, l'interaction de l'onde stationnaire avec les moyens de conversion est maximale.

Le choix des première et seconde distances permet donc de moduler dans les moyens de conversion, en fonction de la longueur d'onde, la valeur du champ électrique résultant de la propagation de l'onde lumineuse à l'intérieur du dispositif. Il suffit donc que les moyens de conversion soient sensibles au champ électrique pour que leur réponse soit modulée. C'est notamment le cas lorsque les moyens de conversion sont réalisés sous la forme d'un photodétecteur dont l'absorption est proportionnelle au carré du champ électrique, le dispositif fonctionnant alors en réception. C'est aussi le cas, par réciprocité, pour un photoémetteur, le dispositif fonctionnant alors en émetteur.

Selon l'invention, les moyens de conversion peuvent être réalisés postérieurement aux moyens de réflexion et aux moyens de filtrage. Il est donc désormais possible de mettre en oeuvre une technologie monolithique. Par exemple, le dispositif peut être intégralement réalisé par une technique d'épitaxie de matériaux semiconducteurs de type III-V, du type de celle utilisée pour réaliser les lasers à cavité verticale. Des techniques de micro-usinage peuvent être également utilisées.

Grâce à l'invention, il est possible d'utiliser des moyens de conversion de types photodétecteur ou photoémetteur ou encore capables d'assurer un contrôle spatial de l'onde (stationnaire) filtrée, par exemple par diffraction.

Dans un mode de réalisation avantageux, les moyens de filtrage sont réalisés sous la forme d'une cavité résonnante, par exemple de type Fabry-Pérot, la cavité étant intercalée entre deux miroirs de Bragg formés d'alternances d'une couche de matériau d'indice optique élevé et d'une couche de matériau d'indice optique faible.

A titre d'exemple, les couches d'indices optiques élevé et faible peuvent être respectivement réalisées en Silicium (Si) et en Silice (SiO₂), la cavité étant réalisée en Silice (SiO₂).

Dans une variante particulièrement intéressante, les couches d'indices optiques élevé et faible peuvent être respectivement réalisées dans un matériau semi conducteur et par une couche d'air, la cavité étant une couche d'air. Dans ce cas, il est avantageux que le premier miroir de Bragg comprenne des couches semiconductrices présentant des dopages d'un même type P, respectivement N, et que le second miroir de Bragg comprenne des couches semiconductrices présentant des dopages d'un même type N, respectivement P, ces couches étant séparées par des espaceurs, de préférence non intentionnellement dopés (I), de manière à définir une structure de type PIN, respectivement NIP et étant propres à être placées à des potentiels électriques respectifs choisis. La variation des polarisations permet en effet de déplacer l'une au moins des couches semiconductrices dopées N, respectivement. P, relativement aux autres couches dopées P, respectivement N, et donc de moduler la longueur d'onde de filtrage des moyens de filtrage.

Bien entendu, les épaisseurs, compositions et dopages respectifs des couches et espaceurs sont choisis de sorte que la structure présente une fonction de transfert optique adaptée au filtrage en longueur d'onde.

Dans le but de renforcer l'interaction entre l'onde stationnaire filtrée et les moyens de conversion, on pourra prévoir en amont de ces derniers une couche semi-réfléchissante.

L'invention concerne également certaines utilisations du dispositif présenté ci-avant, et notamment dans les domaines de la commutation optique de faisceaux de lumière, du balayage spatial de faisceaux de lumière, de l'affichage matriciel en couleur, et du multiplexage en longueur d'onde.

D'autres caractéristiques et avantages de l'invention apparaîtront à l'examen de la description détaillée ci-après, et des dessins annexés, sur lesquels:
- la figure 1 est une vue en coupe très schématique d'un dispositif photodétecteur selon l'invention,
- la figure 2 est une vue en coupe transversale d'un exemple de réalisation d'un dispositif selon l'invention adapté à la photodétection sélective en longueur d'onde, et
- la figure 3 est une vue en coupe transversale d'un autre exemple de réalisation d'un dispositif selon l'invention adapté à la photodétection sélective en longueur d'onde et accordable ;
- la figure 4 est une vue en coupe très schématique d'un dispositif photoémetteur selon l'invention.

Les dessins annexés sont, pour l'essentiel, de caractère certain. En conséquence, ils pourront non seulement servir à compléter l'invention, mais aussi contribuer à sa définition, le cas échéant.

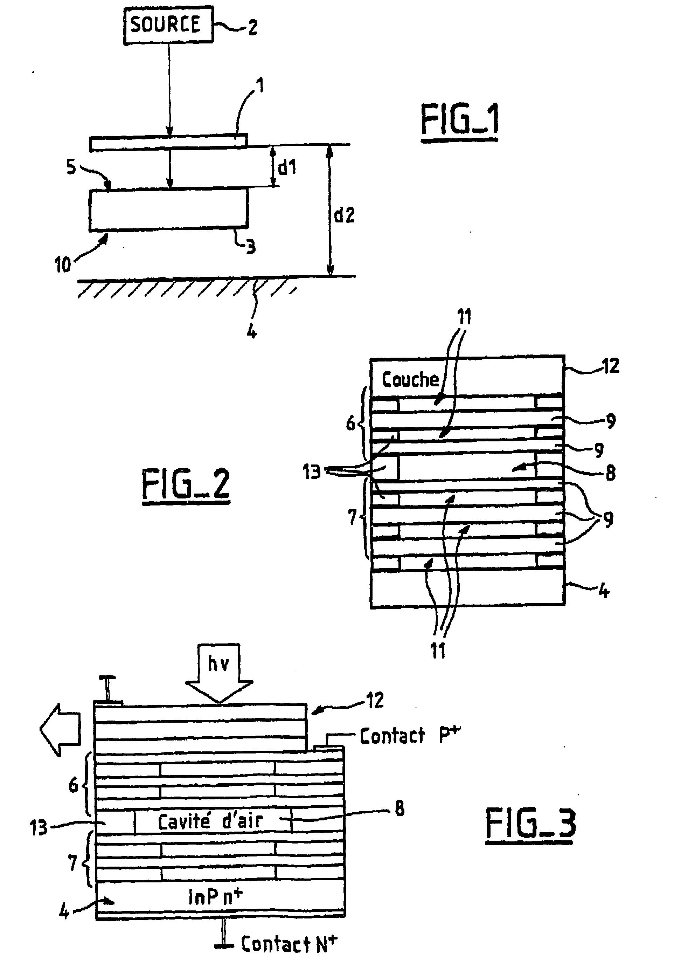

On se réfère tout d'abord à la figure 1 pour décrire les éléments essentiels du dispositif photodétecteur selon l'invention.

Ce dispositif comporte des premiers moyens de conversion 1 capables de recevoir des ondes lumineuses provenant d'une source 2 d'ondes lumineuses, dites « ondes incidentes », et de transmettre ces ondes à des moyens de filtrage 3.

Ces moyens de filtrage 3 sont destinés à sélectionner la partie des ondes incidentes qui présente une longueur d'onde centrée sur une valeur choisie λ_{C}. Plus précisément, les moyens de filtrage sont agencés pour sélectionner les longueurs d'ondes qui sont comprises dans un intervalle Δλ dont la valeur centrale est λ_{C}. L'intervalle s'étend donc sensiblement entre les valeurs λ_{C} - Δλ/2 et λ_{C} + Δλ/2. On entend ici par sélectionner, le fait de ne laisser passer (ou encore de ne transmettre) que les longueurs d'onde comprises dans l'intervalle Δλ. Bien entendu, les moyens de filtrage peuvent être agencés pour ne stopper que les ondes lumineuses dont la longueur d'onde est comprise dans au moins une plage choisie (filtre passe bande ou passe haut ou encore passe bas).

Le dispositif selon l'invention comporte en outre des moyens de réflexion 4, placés en aval des moyens de filtrage 3, et destinés à réfléchir vers ces moyens de filtrage 3 les ondes filtrées de sorte qu'ils laissent passer les ondes filtrées et réfléchies pour qu'elles parviennent au niveau des moyens de conversion 1.

Dans le dispositif selon l'invention, les moyens de conversion 1 se trouvent, par conséquent, placés entre la source d'ondes lumineuses 2 et les moyens de filtrage 3.

Selon une caractéristique essentielle de l'invention, les moyens de conversion 1 sont placés à une première distance d1 de la face "d'entrée" (ou première face) des moyens de filtrage 3. Dans le même temps, les moyens de conversion 1 doivent être espacés des moyens de réflexion 4 d'une seconde distance d2.

La première distance d1 est choisie de sorte que l'onde incidente émise par la source 2 et l'onde réfléchie par la face d'entrée 5 (du fait que sa longueur d'onde n'est pas comprise dans l'intervalle Δλ) créent une première onde stationnaire dont le champ électrique associé présente un noeud à l'intérieur des moyens de conversion 1, et plus précisément dans leur partie active. Il est clair que, pour que cette condition soit vérifiée, l'épaisseur de la partie active des moyens de conversion 1 doit être très petite devant la longueur d'onde λ_{C} de sorte que le champ électrique ne puisse pas présenter plusieurs valeurs sensiblement différentes de celle qu'il possède en son noeud. Typiquement, l'épaisseur optique équivalente maximale de la partie active des moyens de conversion 1 est de l'ordre de 0,1 λ_{C}.

Lorsque cette première condition est remplie, l'onde réfléchie par la face d'entrée 5 des moyens de filtrage 3 n'interagit pas, ou peu, avec la partie active, si bien qu'elle n'est pas traitée. Par exemple, lorsque la couche active est une couche absorbante adaptée à la détection des ondes de longueur d'onde λ_{C}, l'absorption est minimale lorsque la valeur du champ électrique associé à la première onde stationnaire est sensiblement égale à sa valeur au niveau du noeud.

Pour un angle de phase de réflexion, sensiblement égal à 180°, sur la face d'entrée 5 des moyens de filtrage 3, la première condition est réalisée lorsque la première distance d1 est égale à kλ_{C}/2, k étant un entier positif ou nul.

Une fois la première distance d1 fixée, on détermine la seconde distance d2. Pour ce faire, on détermine la distance qui doit séparer les moyens de réflexion 4 de la partie active des moyens de conversion 1 pour qu'une seconde onde stationnaire soit créée par interaction entre l'onde transmise et filtrée par les moyens de filtrage 3 et l'onde transmise, filtrée et réfléchie par les moyens de filtrage 3 et les moyens de réflexion 4, et que dans le même temps, le champ électrique associé à cette seconde onde stationnaire présente un ventre à l'intérieur des moyens de conversion 1.

Dans ces conditions, l'interaction entre la partie active des moyens de conversion 1 et la seconde onde stationnaire est maximale. Par conséquent, lorsque les deux conditions relatives aux distances d1 et d2 sont remplies, les moyens de conversion 1 ne sont sensibles qu'aux ondes dont la longueur d'onde se trouve comprise dans l'intervalle Δλ (ou bande de transmission des moyens de filtrage 3).

On obtient ainsi un dispositif de conversion sélectif en longueur d'onde, dans lequel la partie de conversion se trouve placée sur le chemin optique de l'onde incidente, avant les moyens de filtrage et non pas à l'intérieur ou après ces moyens de filtrage. Cela permet de simplifier la réalisation du dispositif sur le plan technologique.

Un tel dispositif peut être utilisé dans de nombreux domaines, selon le type de conversion qu'il effectue. Ainsi, les moyens de conversion 1 peuvent être des moyens de détection comportant une couche active mince d'absorption, typiquement d'une épaisseur optique inférieure à environ 0,1 λ_{C} (c'est-à-dire petite devant la longueur d'onde de la seconde onde stationnaire). En variante, la détection peut s'effectuer à l'aide d'une structure multicouches, de type multipuits quantiques, les couches pouvant être séparées les unes des autres d'une distance Δλ_{C}/2 (k étant un entier positif ou nul) de manière à suivre la périodicité des première et seconde ondes stationnaires. A titre d'exemple, la (ou les) couche(s) mince(s) d'absorption sont réalisées à l'aide d'un procédé de dépôt conventionnel tel que celui utilisé en microélectronique silicium, la couche mince d'absorption étant de type bolométrique ou photoconductrice.

La partie active des moyens de conversion 1 peut également être une partie émettrice apte, par exemple, à électroluminescer ou photoluminescer ou encore à fluorescer sous l'action d'un courant électrique délivré par des électrodes formées sur le dispositif. Dans ce cas, le dispositif peut faire partie de matrices de sources colorées actives pour l'affichage en couleurs. Pour fabriquer un écran d'affichage couleur, on pourra par exemple commencer par réaliser une matrice de filtres diélectriques sur un miroir "inférieur" reposant sur un substrat de grande dimension. Puis, on réalise des sources électroluminescentes qui n'ont plus à supporter les étapes technologiques (et notamment les montées en température nécessaires à la fabrication des filtres). Cela est particulièrement avantageux dans le cas des sources de type "OLED" (pour « Organic Light Emitting Diode »), qui comprennent des matériaux émetteurs organiques luminescents, à large bande spectrale, qui ne supportent pas les étapes thermiques agressives.

Mais les moyens de conversion pourront être adaptés au contrôle spatial des ondes filtrées. Il pourra s'agir, par exemple, de moyens de diffraction, tels qu'un réseau de diffraction, permettant de sélectionner une direction privilégiée de l'onde filtrée en fonction de la valeur de son champ électromagnétique associé. Ce mode de réalisation peut être particulièrement intéressant dans le domaine de la commutation de faisceaux lumineux, ou bien dans le domaine du balayage spatial, notamment.

Les moyens de filtrage sélectif sont de préférence réalisés sous la forme d'une cavité résonnante de type Fabry-Pérot, comportant deux miroirs de Bragg séparés par une cavité résonnante. Chaque miroir de Bragg peut être constitué par trois couches de silicium (Si), de type quart d'onde, séparées les unes des autres par deux couches de silice (SiO₂), également de type quart d'onde, tandis que la cavité résonnante est en silice (SiO₂). Ce mode de réalisation permet de transmettre (ou filtrer) des longueurs d'onde de 1550 nanomètres.

Un tel filtre Fabry-Pérot peut être combiné à des moyens de réflexion 4 tels qu'un miroir réalisé à l'aide d'une couche d'aluminium de 200 nanomètres d'épaisseur, par exemple.

Dans ce mode de réalisation en technologie silicium, le premier espacement d1 est réalisé en intercalant une couche de silicium d'une épaisseur de 0,475 λ_{C} entre la face d'entrée 5 du filtre 3 et la couche active, par exemple une couche d'absorption d'une épaisseur optique de 0,05 λ_{C} dont l'absorption intrinsèque en champ libre est d'environ 3% à 1550 nanomètres. Par ailleurs, le second espacement. d2 est réalisé en intercalant, entre le miroir d'aluminium 4 et la face de sortie 10 du filtre 3 (opposée à la face d'entrée 5), une couche de silice (SiO₂) d'une épaisseur optique de 0,694 λ_{C}.

Une variante, particulièrement intéressante sur le plan de la mise en oeuvre technologique, consiste à intégrer les moyens de réflexion 4 dans le second miroir de Bragg du filtre Fabry-Pérot 3, c'est-à-dire en renforçant la réflectivité de ce second miroir de Bragg par une augmentation du nombre d'alternances quart-d'onde. Par exemple, on peut remplacer la couche d'aluminium servant de miroir de réflexion 4 par une, et de préférence deux, alternances supplémentaires aux trois alternances initiales, sans que les performances du dispositif ne soient modifiées.

Il est important de noter que, du fait que l'onde lumineuse filtrée traverse deux fois le filtre dans des directions opposées, la valeur à mi-hauteur de la bande passante de la courbe d'absorption (de conversion) est sensiblement deux fois plus étroite que celle du filtre seul. Il en résulte que le dispositif selon l'invention permet d'atteindre des performances de sélectivité équivalentes à celles des dispositifs de l'art antérieur avec un nombre d'alternances réduit pour chaque miroir de Bragg du filtre 3.

D'une manière générale, l'interaction entre la seconde onde stationnaire et la couche active des moyens de conversion 1 peut être sensiblement améliorée si l'on rajoute un réflecteur partiel (ou semi-réfléchissant) en amont des moyens de conversion, par exemple avant la couche active de conversion. Cela permet en effet d'accentuer l'amplitude de l'onde stationnaire à l'intérieur de cette couche active et de réduire la bande passante tout en offrant une plus forte réjection des ondes lumineuses réfléchies en dehors de la bande passante.

A titre d'exemple, et dans le cas d'une couche active adaptée à l'absorption, un réflecteur partiel permet d'obtenir une augmentation de l'absorption maximale de 30% à 80%, environ, avec une réduction d'environ 0,5 nanomètre de la largeur à mi-hauteur de la courbe d'absorption.

Mais d'autres combinaisons de matériaux diélectriques, de matériaux de réflexion et de matériaux actifs peuvent être envisagées selon la gamme spectrale visée. Le choix des matériaux et des épaisseurs des couches, appropriés aux différentes applications de l'invention, peuvent être facilement déterminés par l'homme de l'art une fois connu l'objet de l'invention

Ce mode de réalisation en technologie silicium peut être envisagé, par exemple, pour la production de matrices de photodétecteurs sélectifs à diverses longueurs d'onde fixes. On réalise une structure multicouches à base de matériaux silicium/silice, à l'aide d'une technique plasma CVD sur substrat silicium. Puis, les couches semi-conductrices monocristallines qui permettent de réaliser des photodiodes sont reportées sur la microcavité selon une méthode dite "de collage moléculaire" bien connue de l'homme du métier. Les photodiodes de conversion sont ensuite élaborées selon des techniques classiques, par exemple celle utilisée pour la fabrication de lasers à cavités verticales.

On se réfère maintenant plus particulièrement à la figure 2 pour décrire une variante de réalisation des moyens de filtrage 3, pouvant être mise en oeuvre à l'aide d'une technologie monolithique. De plus, comme on le verra plus loin, cette variante permet de réaliser des dispositifs qui ne sont pas seulement sélectifs en longueur d'onde, mais également accordables électriquement.

Ici, la sélection et l'accordabilité en longueur d'onde sont obtenues avec une structure Micro-Opto-Electro-Mécanique (plus connue sous l'acronyme MOEM). Il s'agit de structures pouvant être réalisées à partir de matériaux semi-conducteurs, et par exemple dans des matériaux semiconducteurs de type III-V. Bien entendu, d'autres types de matériaux peuvent être envisagés, comme par exemple les couches minces traditionnelles.

Ces structures comprennent une microcavité verticale, micro-usinée par une technique de micro-usinage de surface, et déformable mécaniquement par variation des potentiels électriques auxquels sont placées certaines de ses couches semi-conductrices. Plus précisément, la structure est un résonateur optique "vertical" de type Fabry-Pérot comportant une cavité optique, constituée d'une lame d'air et délimitée verticalement par deux miroirs de Bragg 6 et 7. Les miroirs (ou réflecteurs) de Bragg 6,7 sont formés par des alternances de couches quart d'onde d'air et de semi-conducteurs, par exemple, en arséniure de gallium (GaAs) ou en phosphure d'indium (InP). Mais ces couches peuvent également être des hétérostructures de type InGaAs/InP ou InAlAs/InGaAlAs déposées sur un substrat d'InP, ou de type AlAs/GaAs déposées sur un substrat GaAs, ou encore de type InGaP/GaAs déposées sur un substrat GaAs.

Bien entendu, ces matériaux ne constituent que des exemples préférentiels.

Dans l'exemple illustré sur la figure 2, les couches semiconductrices 9 sont espacées entre-elles par des espaceurs 13 réalisés également dans des matériaux semiconducteurs et définissant des logements remplis d'air. Les couches 9 définissent des lames qui peuvent être déformées (courbées) par contrainte électrostatique, et qui par conséquent peuvent induire une déformation de la cavité optique 8, remplie d'air, qui modifie la réponse spectrale du dispositif et lui confère son accordabilité en longueur d'onde.

Cette déformation des lames ne peut cependant être obtenue qu'avec des dopages particuliers des couches des deux miroirs de Bragg 6,7. En effet, la déformation ne peut être obtenue qu'en présence d'au moins une sous-structure de type PIN, notamment pour délimiter la cavité résonnante 8.

Par exemple, les couches semi-conductrices 9 du premier miroir de Bragg 6 sont intentionnellement dopées de type N ou de type P, et les couches semiconductrices 9 et 12 du second miroir de Bragg 7 sont intentionnellement dopées de type P ou de type N, tandis que les espaceurs 13 qui délimitent la cavité résonnante sont non intentionnellement dopés (de type I), de manière à définir une structure de type NIP ou PIN dont les couches sont placées à des potentiels électriques respectifs choisis. Les autres espaceurs qui permettent de séparer les couches d'un même miroir de Bragg sont soit intentionnellement dopés, selon le même type que les couches, soit non intentionnellement dopés (I). Dans le mode de réalisation présenté ci-avant, la structure est de type PPPINNN ou NNNIPPP.

En polarisant en inverse la sous-structure PIN, on obtient un déplacement vertical contrôlé d'une ou plusieurs lames, par voie électrostatique. Plus précisément, sous l'effet de la polarisation, le champ électrique qui s'établit entre les deux lames adjacentes qui délimitent la cavité résonnante 8 induit une force électrostatique qui rapproche ces deux lames, diminuant ainsi la longueur d'onde de résonance λ_{C} de la cavité.

La longueur d'onde de filtrage des moyens de filtrage peut être modulée par déplacement de l'une au moins des couches semiconductrices dopées N, respectivement P, relativement aux autres couches dopées P, respectivement N, par une variation de leurs polarisations respectives.

Des modulations plus complexes de la fonction de transfert du dispositif peuvent être obtenues en insérant à volonté d'autres lames, pour constituer d'autres sous-structures de type PIN, d'orientation choisie grâce à un dopage indépendant de chacune des lames suspendues. Les sous-structures doivent être polarisées en inverse si on souhaite que leurs lames suspendues soient soumises au champ électrique destiné à les déplacer.

Ainsi, la structure pourrait être du type PINIPIN ou PPPINIPPP ou NNNIPINIPPP, par exemple.

Chaque sous-structure PIN ou NIP constitue une jonction PIN bien connue de l'homme du métier.

Les tensions sont appliquées aux couches semiconductrices par des contacts ohmiques, de préférence réalisés en alliages de type AuGe, ou bien Pd-AuGe, ou encore Ti-Pt-Au. Ces contacts sont formés sur les couches placées aux deux extrémités de la structure, ou bien sur chaque couche semiconductrice de la structure, ou bien encore sur les couches d'extrémité et sur certaines couches intermédiaires.

Compte tenu de la forte différence entre les indices optiques de l'air (n=1, indice faible) et du semi-conducteur constituant les lames (n=3,2, indice élevé), un faible nombre d'alternances est nécessaire pour réaliser le filtrage optique qui assure la sélectivité en longueur d'onde (λ_{C}).

Dans l'exemple illustré sur la figure 2, la couche active (par exemple une couche d'absorption) est réalisée en amont du résonateur optique (ou « au-dessus ») et se trouve incluse dans la couche de haut indice 12 de la première alternance du premier miroir de Bragg 6. Bien entendu, la couche active de conversion 1 pourrait être réalisée en amont de la première alternance, et dans ce cas les couches du premier miroir de Bragg 6 présentent toutes la même épaisseur.

L'intégration de la couche active de conversion dans le premier miroir de Bragg est détaillée sur la figure 3. Dans cet exemple, la couche active est une photodiode réalisée sous la forme d'une structure à multipuits quantiques, dans laquelle chaque multipuit constitue une couche absorbante. Une telle structure à multipuits quantiques est réalisée avant l'étape de micro-usinage de l'hétérostructure au-dessus de laquelle elle est située et qui conduit à la constitution de la structure multilames formant le filtre 3.

De même, et comme indiqué précédemment, on peut intégrer les moyens de réflexion 4 dans la dernière couche semi-conductrice du second miroir de Bragg 7 du filtre Fabry-Pérot 3. En fait, la réflexion est obtenue en renforçant la réflectivité de ce second miroir de Bragg par une augmentation du nombre d'alternances quart-d'onde. Par exemple, on peut remplacer la couche d'aluminium servant de miroir de réflexion 4 en rajoutant deux alternances aux trois alternances initiales, sans que les performances du dispositif ne soient modifiées.

Grâce à l'invention, il est donc possible de réaliser un dispositif entièrement par épitaxie de matériaux semi-conducteurs de type III-V, ou bien par une technique d'épitaxie combinée à une ou plusieurs techniques d'attaque chimique sélective. Différentes techniques d'épitaxie peuvent être envisagées, dès lors qu'elles permettent un contrôle convenable des épaisseurs des couches. On citera par exemple l'épitaxie par jet moléculaire (plus connue sous l'acronyme anglais MBE), ou bien la déposition chimique en phase vapeur d'organométalliques à basse pression (plus connue sous l'acronyme anglais « LP-MOCVD »), ou encore l'épitaxie par jet chimique sous pression (plus connue sous l'acronyme anglais « CBE »).

Ces techniques permettent un contrôle extrêmement précis des épaisseurs et assurent d'excellentes qualités cristallines et des interfaces très abruptes. De plus, elles offrent un contrôle de la composition et du dopage d'une très grande précision. Enfin, elles permettent un excellent contrôle des contraintes mécaniques résiduelles.

Il existe, par ailleurs, de nombreuses techniques de gravure chimique, notamment par voie humide, permettant un micro-usinage sélectif des parties suspendues (lames). On citera à titre d'exemple les techniques de gravure par voie humide de type FeCl₃:H₂O ou HF:H₂O₂:H₂O pour le système InGaAs/InP, ou bien de type HCl :H₂O ou HCl :H₃PO₄ pour les systèmes InAlAs/InGaAlAs et GalnP/GaAs, ou encore de type HF pour le système AIAs/GaAs.

Bien entendu, il ne s'agit que d'exemples de techniques de croissance et de gravure, parmi d'autres.

Le dispositif selon l'invention offre un avantage technologique indéniable dans la mesure où il permet de mettre en oeuvre une technologie monolithique à partir de procédés bien maîtrisés pouvant être conduits successivement et de manière indépendante. Il permet de satisfaire aux spécifications requises pour le multiplexage en longueur d'onde, utilisé dans le domaine des télécommunications optiques ("wavelength multiplexing systems" ou WDM), notamment en termes de sélectivité, de gamme d'accordabilité et de bande passante électrique. A titre d'exemple, il est désormais possible d'atteindre des bandes passantes de l'ordre de 2,5 GHz.

Ces dispositifs pourront être utilisés dans d'autres domaines techniques, et notamment pour le contrôle industriel (par exemple dans l'agro-alimentaire), pour la microspectrométrie, notamment dans le domaine de l'environnement (détection de transmission ou d'absorption de gaz), ou encore pour certaines analyses médicales utilisant des techniques de spectroscopies ou pour l'affichage à l'aide d'écrans matriciels couleur, et d'une façon plus générale, dans tous les domaines nécessitant un traitement optique du signal lumineux.

L'invention ne se limite pas aux modes de réalisation de dispositif décrits ci-avant, seulement à titre d'exemple, mais elle englobe toutes les variantes que pourra envisager l'homme de l'art dans le cadre des revendications ci-après.

Ainsi, le dispositif pourra comporter, en amont des moyens de conversion, une couche semi-réfléchissante destinée à renforcer l'interaction entre l'onde stationnaire filtrée et les moyens de conversion.

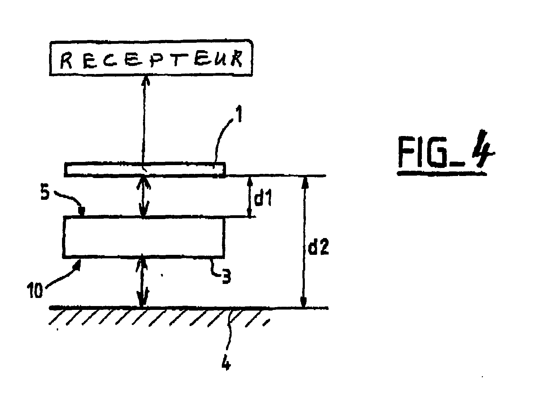

Un dispositif photoémetteur selon l'invention est représenté schématiquement en figure 4. Ce dispositif a sensiblement la même structure que le dispositif photorécepteur de la figure 1 et fonctionne selon le même principe, la source lumineuse 2 de la figure 1 étant remplacée par un récepteur 14.

## Revendications

1. Dispositif optoélectronique comprenant des moyens (1) de conversion de type photodétecteur ou photoémetteur, des moyens (3) de filtrage et des moyens (4) de réflexion des ondes lumineuses, **caractérisé en ce que** les moyens de filtrage (3) sont placés entre les moyens (1) de conversion et les moyens (4) de réflexion, à une distance d1 des moyens (1) de conversion pour transmettre une partie spectrale choisie des ondes lumineuses provenant des moyens (1) de conversion et à réfléchir vers lesdits moyens de conversion une partie spectrale complémentaire de ces ondes, les moyens de réflexion (4) étant placés à une distance d2 des moyens (1) de conversion pour renvoyer la partie spectrale choisie transmise par les moyens de filtrage (3) vers lesdits moyens de filtrage, la distance d1 étant choisie de sorte que les ondes transmises par les moyens (1) de conversion et la partie spectrale complémentaire réfléchie par les moyens de filtrage (3) créent une première onde stationnaire avec un noeud de champ électrique dans lesdits moyens (1) de conversion, et la distance d2 étant choisie de sorte que la partie spectrale choisie transmise par les moyens de filtrage (3) et la partie spectrale choisie et réfléchie par les moyens de réflexion (4) créent une seconde onde stationnaire avec un ventre de champ électrique dans lesdits moyens (1) de conversion.

2. Dispositif selon la revendication 1, **caractérisé en ce que** lesdits moyens (1) de conversion sont agencés pour recevoir des ondes lumineuses à filtrer d'une source d'ondes lumineuses externe, et pour détecter, par absorption, la seconde onde stationnaire.

3. Dispositif selon la revendication 2, **caractérisé en ce que** lesdits moyens (1) de conversion comprennent une couche d'absorption d'épaisseur petite devant la longueur d'onde centrale de la partie spectrale choisie.

4. Dispositif selon la revendication 2, **caractérisé en ce que** lesdits moyens (1) de conversion comprennent une multiplicité de couches d'absorption espacées entre elles d'une distance sensiblement égale à un nombre entier de fois la moitié de la longueur d'onde de la seconde onde stationnaire.

5. Dispositif selon l'une des revendications 2 à 4, **caractérisé en ce que** la couche d'absorption est de type bolométrique ou photoconductrice.

6. Dispositif selon la revendication 1, **caractérisé en ce que** lesdits moyens (1) de conversion comprennent une photodiode comportant une couche active mince d'épaisseur petite devant la longueur d'onde de la seconde onde stationnaire.

7. Dispositif selon la revendication 1, **caractérisé en ce que** lesdits moyens (1) de conversion comprennent une photodiode à multipuits quantiques.

8. Dispositif selon la revendication 1, **caractérisé en ce que** lesdits moyens (1) de conversion sont destinés à émettre des photons formant lesdites ondes lumineuses à filtrer par lesdits moyens de filtrage (3).

9. Dispositif selon la revendication 8, **caractérisé en ce que** lesdits moyens (1) de conversion sont agencés pour émettre de la lumière par un mécanisme choisi dans le groupe comprenant la photoluminescence, l'électroluminescence et la fluorescence.

10. Dispositif selon la revendication 1, **caractérisé en ce que** lesdits moyens (1) de conversion comprennent un réseau de diffraction pour contrôler spatialement la seconde onde stationnaire.

11. Dispositif selon l'une des revendications 1 à 10, **caractérisé en ce que** les moyens de filtrage (3) comportent une structure à cavité résonnante (8) intercalée entre deux miroirs de Bragg formés d'alternances d'une couche d'indice optique élevé et d'une couche d'indice optique faible.

12. Dispositif selon la revendication 11, **caractérisé en ce que** les couches d'indice optique élevé sont réalisées en Silicium (Si) et les couches d'indice optique faible sont réalisées en Silice (SiO2), ladite cavité étant réalisée en Silice (SiO2).

13. Dispositif selon la revendication 11, **caractérisé en ce que** les couches d'indice optique élevé sont réalisées dans un matériau semi conducteur et les couches d'indice optique faible sont des couches d'air, ladite cavité étant une couche d'air.

14. Dispositif selon la revendication 13, **caractérisé en ce que** le premier miroir de Bragg (6) comprend des couches semiconductrices (9) présentant des dopages d'un même type P, respectivement N, tandis que le second miroir de Bragg (7) comprend des couches semiconductrices (9) présentant des dopages d'un même type N, respectivement P, ces couches (9) étant séparées par des espaceurs (13) non intentionnellement dopés (1) de manière à définir une structure de type PIN, respectivement NIP et étant propres à être placées à des potentiels électriques respectifs choisis.

15. Dispositif selon la revendication 14, **caractérisé en ce que** la longueur d'onde de filtrage des moyens de filtrage est modulable par déplacement de l'une au moins des couches semiconductrices dopées N, respectivement P, relativement aux autres couches dopées P, respectivement N, par une variation de leurs polarisations respectives.

16. Dispositif selon l'une des revendications 11 à 15, **caractérisé en ce que** le second miroir de Bragg (7) comporte au moins une alternance supplémentaire qui définit les moyens de réflexion (4).

17. Dispositif selon l'une des revendications 1 à 16, **caractérisé en ce qu'**il comprend en amont des moyens (1) de conversion une couche semi-réfléchissante.

18. Dispositif selon l'une des revendications 1 à 17, **caractérisé en ce que** les moyens de filtrage sont agencés pour transmettre les ondes lumineuses dont la longueur d'onde est centrée sur une valeur choisie.

19. Dispositif selon l'une des revendications 1 à 17, **caractérisé en ce que** les moyens de filtrage sont agencés pour stopper les ondes lumineuses dont la longueur d'onde est comprise dans au moins une plage choisie.

20. Utilisation du dispositif selon l'une des revendications 1 à 19 pour la commutation optique de faisceaux de lumière.

21. Utilisation du dispositif selon l'une des revendications 1 à 19 pour le balayage spatial de faisceaux de lumière.

22. Utilisation du dispositif selon l'une des revendications 1 à 19 pour l'affichage matriciel en couleur.

23. Utilisation du dispositif selon l'une des revendications 1 à 19 pour le multiplexage en longueur d'onde.

## Claims

1. An optoelectronic device including light energy converter means (1) of the photodetector or photoemitter type, filler means (3) and reflector means (4) adapted to reflect the light waves, **characterized in that** the filter means (3) are between the converter means (1) and the reflector means (4),at a distance (d1) from the converter means (1) to transmit a chosen spectral portion of the light waves incident from the converter means (1) and to reflect a complementary spectral portion of said waves towards the converter means, the reflector means being at a distance (d2) from the converter means (1) to reflect the chosen spectral portion transmitted by the filter means (3) towards said filter means, the distance (d1) being chosen so that the waves transmitted by the converter means (1) and the complementary spectral portion reflected by said filter means (3) create a first standing wave with an electric field node in said converter means (1) and the distance (d2) being chosen so that the chosen spectral portion transmitted by the filter means (3)and the chosen spectral portion reflected by said reflector means (4) create a second standing wave with an electrical field antinode in said converter means (1).

2. A device according to claim 1, **characterized in that** said converter means (1) are adapted to receive light waves to be filtered from an external light wave source and to detect the second standing wave by absorption.

3. A device according to claim 2, **characterized in that** said converter meals (1) include an absorption layer having a small thickness in comparison to the central wavelength of the chosen spectral portion.

4. A device according to claim 2, **characterized in that** said converter means (1) include a multiplicity of absorption layers spaced from each other at a distance substantially equal to an integer number of times half the wavelength of the second standing wave.

5. A device according to any one of claims 2 to 4, **characterized in that** the absorption layer is of the bolometric or phococonductive type.

6. A device according to claim 1, **characterized in that** said converter means (1) include a photodiode having a thin active Layer having a small thickness compared to the wavelength of the second standing wave.

7. A device according to claim 1, **characterized in that** said converter means (1) include a multiple quantum well photodiode.

8. A device according to claim 1, **characterized in that** said converter means (1) are adapted to emit photons forming said light waves to be filtered by said filter means (3).

9. A device according to claim 8, **characterized in that** said converter means (1) are adapted to emit light by a mechanism chosen from the group comprising photoluminescence, electroluminescence and fluorescence.

10. A device according to claim 1, **characterized in that** said converter means (1) comprise a diffraction grating to control the second standing wave spatially.

11. A device according to any one of claims 1 to 10, **characterized in that** the filter means (3) include a resonant cavity structure (8) interleaved between two Bragg mirrors formed of alternating high refractive index and low refractive index layers.

12. A device according to claim 11, **characterized in that** the high refractive index layers are layers of silicon (Si), the low refractive index layers are layers of silica (SiO₂) and said cavity consists of silica (SiO₂).

13. A device according to claim 11, **characterized in that** the high refractive index layers are layers of a semiconductor material, the low refractive index layers are layers of air, and said cavity is a layer of air.

14. A device according to claim 13, **characterized in that** the first Bragg mirror (6) includes semiconductor layers (9) with the same P or N type doping, the second Bragg mirror (7) includes semiconductor layers (9) with the same opposite N or P type doping, and the layers (9) are separated by spacers (13) that are not intentionally doped (I-type) to define a PIN or NIP structure, and are adapted to have respective chosen electrical potentials applied to then.

15. A device according to claim 14, **characterized in that** the filter wavelength of the filter means can be modulated by moving one or more of the N or P doped semiconductor layers relative to the opposite P or N doped layers by varying their respective biasing.

16. A device according to any one of claims 11 to 15, **characterized in that** the second Bragg mirror (7) includes at least one additional alternation defining the reflector means (4).

17. A device according to any one of claims 1 to 16, **characterized in that** it includes a semi-reflecting layer on the upstream side of the converter means (1).

18. A device according to any one of claims 1 to 17, **characterized in that** the filter means are adapted to transmit light waves whose wavelength is centered on a chosen value.

19. A device according to any one of claims 1 to 17, **characterized in that** the filter means are adapted to stop light waves whose wavelength is in at least one chosen range.

20. Use of a device according to any one of claims 1 to 19 for optically switching light beams.

21. Use of a device according to any one of claims 1 to 19 for spatially scanning light beams.

22. Use of a device according to any one of claims 1 to 19 for color matrix displays.

23. Use of a device according to any one of claims 1 to 19 for wavelength multiplexing.

## Patentansprüche

1. Optoelektronische Vorrichtung umfassend Mittel (1) zur Konversion vom Typ eines Photodetektors oder Photoemitters, Mittel (3) zum Filtern und Mittel (4) zur Reflexion von Lichtwellen, **dadurch gekennzeichnet, dass** die Filtermittel (3) zwischen die Konversionsmittel (1) und die Reflexionsmittel (4) in einem Abstand d1 von den Konversionsmitteln (1) platziert sind, um einen ausgewählten Spektralteil der Lichtwellen, die von den Konversionsmitteln (1) kommen, zu transmittieren und einen komplementären Spektralteil dieser Wellen zu den Konversionsmitteln zu reflektieren, wobei die Reflexionsmittel (4) in einem Abstand d2 von den Konversionsmitteln platziert sind, um den von den Filtermitteln (3) transmittierten ausgewählten Spektralteil zu den Filtermitteln zurückzuwerfen, wobei der Abstand d1 derart gewählt ist, dass die von den Konversionsmitteln (1) transmittierten Wellen und der von den Filtermitteln (3) reflektierte komplementäre Spektralteil eine erste stationäre Welle mit einem elektrischen Feldknoten in den Konversionsmitteln (1) bilden, und der Abstand d2 derart gewählt ist, dass der von den Filtermitteln (3) transmittierte ausgewählte Spektralteil und der ausgewählte und von den Reflexionsmitteln (4) reflektierte Spektralteil eine zweite stationäre Welle mit einem elektrischen Feldbauch in den Konversionsmitteln (1) bilden.

2. Vorrichtung nach Anspruch 1, **dadurch gekennzeichnet, dass** die Konversionsmittel (1) dazu ausgebildet sind, dass sie zu filternde Lichtwellen von einer externen Lichtwellenquelle empfangen und durch Absorption die zweite stationäre Welle detektieren.

3. Vorrichtung nach Anspruch 2, **dadurch gekennzeichnet, dass** die Konversionsmittel (1) eine Absorptionsschicht umfassen, die eine im Vergleich zur zentralen Wellenlänge des gewählten Spektralteils geringe Dicke aufweist.

4. Vorrichtung nach Anspruch 2, **dadurch gekennzeichnet, dass** die Konversionsmittel (1) eine Mehrzahl von Absorptionsschichten umfassen, die um einen Abstand voneinander beabstandet sind, der im Wesentlichen gleich einem ganzzahligen Vielfachen der halben Wellenlänge der zweiten stationären Welle ist.

5. Vorrichtung nach einem der Ansprüche 2 bis 4, **dadurch gekennzeichnet, dass** die Absorptionsschicht bolometrisch oder photoleitend ist.

6. Vorrichtung nach Anspruch 1, **dadurch gekennzeichnet, dass** die Konversionsmittel (1) eine Photodiode umfassen, die eine dünne aktive Schicht mit einer im Vergleich zur Wellenlänge der zweiten stationären Welle geringen Dicke aufweist.

7. Vorrichtung nach Anspruch 1, **dadurch gekennzeichnet, dass** die Konversionsmittel (1) eine Photodiode mit mehreren Quantentöpfen umfassen.

8. Vorrichtung nach Anspruch 1, **dadurch gekennzeichnet, dass** die Konversionsmittel (1) dazu vorgesehen sind, Photonen zu emittieren, die die von den Filtermitteln (3) zu filternden Lichtwellen bilden.

9. Vorrichtung nach Anspruch 8, **dadurch gekennzeichnet, dass** die Konversionsmittel (1) dazu ausgebildet sind, dass sie nach einem Mechanismus, der ausgewählt ist aus der Gruppe bestehend aus Photolumineszenz, Elektrolumineszenz und Fluoreszenz, Licht emittieren.

10. Vorrichtung nach Anspruch 1, **dadurch gekennzeichnet, dass** die Konversionsmittel (1) ein Beugungsgitter zur räumlichen Kontrolle der zweiten stationären Welle umfassen.

11. Vorrichtung nach einem der Ansprüche 1 bis 10, **dadurch gekennzeichnet, dass** die Filtermittel (3) eine Resonanzraumstruktur (8) aufweisen, die zwischen zwei Bragg-Spiegel eingesetzt ist, die aus Alternanzen einer Schicht mit hohem optischen Index und einer Schicht mit niedrigem optischen Index gebildet sind.

12. Vorrichtung nach Anspruch 11, **dadurch gekennzeichnet, dass** die Schichten mit hohem optischen Index aus Silicium (Si) gebildet sind und die Schichten mit niedrigem optischen Index aus Siliciumoxid (SiO₂) gebildet sind, wobei der Resonanzraum aus Siliciumoxid (SiO₂) gebildet ist.

13. Vorrichtung nach Anspruch 11, **dadurch gekennzeichnet, dass** die Schichten mit hohem optischen Index aus einem Halbleitermaterial gebildet sind und die Schichten mit niedrigem optischen Index Luftschichten sind, wobei der Resonanzraum eine Luftschicht ist.

14. Vorrichtung nach Anspruch 13, **dadurch gekennzeichnet, dass** der erste Bragg-Spiegel (6) Halbleiterschichten (9) umfasst, die Dotierungen eines gleichen P-Typs bzw. N-Typs aufweisen, während der zweite Bragg-Spiegel (7) Halbleiterschichten (9) umfasst, die Dotierungen eines gleichen N-Typs bzw. P-Typs aufweisen, wobei die Schichten (9) durch nicht intentionell dotierte (I) Abstandhalter (13) getrennt sind, um eine Struktur vom PIN-Typ bzw. NIP-Typ zu definieren, und zum Anlegen an entsprechend gewählte elektrische Potentiale geeignet sind.

15. Vorrichtung nach Anspruch 14, **dadurch gekennzeichnet, dass** die Filterwellenlänge der Filtermittel durch Verschieben von mindestens einer der N-dotierten bzw. P-dotierten Halbleiterschichten in Bezug zu anderen P-dotierten bzw. N-dotierten Schichten um eine Variation ihrer zugehörigen Polarisationen modulierbar ist.

16. Vorrichtung nach einem der Ansprüche 11 bis 15, **dadurch gekennzeichnet, dass** der zweite Bragg-Spiegel (7) mindestens eine zusätzliche Alternanz umfasst, die die Reflexionsmittel (4) definiert.

17. Vorrichtung nach einem der Ansprüche 1 bis 16, **dadurch gekennzeichnet, dass** sie vor den Konversionsmittein (1) eine Semireflexionsschicht umfasst.

18. Vorrichtung nach einem der Ansprüche 1 bis 17, **dadurch gekennzeichnet, dass** die Filtermittel dazu ausgebildet sind, die Lichtwellen zu transmittieren, deren Wellenlänge auf einen gewählten Wert zentriert ist.

19. Vorrichtung nach einem der Ansprüche 1 bis 17, **dadurch gekennzeichnet, dass** die Filtermittel dazu ausgebildet sind, die Lichtwellen zu stoppen, deren Wellenlänge mindestens in einem gewählten Bereich gelegen ist.

20. Verwendung der Vorrichtung nach einem der Ansprüche 1 bis 19 für die optische Lichtstrahlvermittlung.

21. Verwendung der Vorrichtung nach einem der Ansprüche 1 bis 19 für die räumliche Abtastung von Lichtstrahlen.

22. Verwendung der Vorrichtung nach einem der Ansprüche 1 bis 19 für die Matrixanzeige in Farbe.

23. Verwendung der Vorrichtung nach einem der Ansprüche 1 bis 19 für das Wellenlängen-Multiplexing.
